# EUROPÄISCHE PATENTSCHRIFT

(11) **EP 2 458 616 B1**
(45) Veröffentlichungstag und Bekanntmachung des Hinweises auf die Patenterteilung: **28.03.2018**
(21) Anmeldenummer: 11190301.9
(22) Anmeldetag: 23.11.2011
(51) Int. Cl.: H01J 37/20

(54) **Halterung für einen elektronenmikroskopischen Probenträger**
Holder for an electron microscopic sample carrier
Support pour un porte-échantillons de microscopie électronique

(30) Priorität: 29.11.2010 AT 19862010
(43) Veröffentlichungstag der Anmeldung: 30.05.2012
(73) Patentinhaber: Leica Microsystems (Schweiz) AG, 9435 Heerbrugg (CH)
(72) Erfinder: Gächter, Leander, 9463 Oberriet (CH)
(74) Vertreter: Patentanwaltskanzlei Matschnig & Forsthuber OG

(56) Entgegenhaltungen:
- EP-A1- 1 868 225
- WO-A1-00/10191
- WO-A2-03/087018
- DE-A1-102009 020 663
- JP-A- H09 102 293
- JP-U- S60 164 761
- US-A1- 2006 289 784
- US-B1- 6 246 060

## Beschreibung

Die Erfindung betrifft eine Ladevorrichtung zum Beladen einer Fassung mit einem elektronenmikroskopischen Probenträger.

Die Erfindung betrifft weiters ein Verfahren zum Beladen einer Fassung mit einem elektronenmikroskopischen Probenträger mittels einer Ladevorrichtung gemäß der Erfindung.

Die Leistung der Elektronenmikroskopie, vor allem der hochauflösenden Transmissionselektronenmikroskopie, ist beachtlich. Dank dieser Technologie konnten in der Erforschung und der Informationsgewinnung bei der Untersuchung von beispielsweise biologischen Ultrastrukturen oder Halbleiterstrukturen große Fortschritte erzielt werden.

Aufgrund des im Transmissionselektronenmikroskop (TEM) herrschenden Hochvakuums und des energiereichen Elektronenstrahls ist üblicherweise eine die Struktur erhaltende Präparation der Probe erforderlich. Insbesondere ist dies bei biologischen Proben der Fall. Für eine hochauflösende transmissionselektronenmikroskopische Abbildung ist es weiters zwingend notwendig, dass die Probe ausreichend dünn ist. TEM-Proben werden zur Untersuchung auf geeigneten Probenträgern aufgebracht. Typischerweise handelt es sich hier um sehr kleine, runde, filigrane Netzchen ("Grids") mit einem Durchmesser von 2 bis 3 mm. Die Netzchen weisen verschiedenartig geformte Löcher (Waben, Schlitze etc.) oder ein Gitter definierter mesh-Zahl auf. Die Netzchen sind üblicherweise mit einem dünnen Film beschichtet und können darüber hinaus noch weitere Beschichtungen aufweisen.

Für die Untersuchung im Elektronenmikroskop muss der Probenträger mit der darauf befindlichen Probe in einer geeigneten Präparathalterungsvorrichtung fixiert werden. Bei den meisten Anwendungen ist die Präparathalterungsvorrichtung als Goniometer realisiert, wobei vorwiegend Side-Entry-Goniometer eingesetzt werden. Bei einteiligen Präparathalterungsvorrichtungen wird der Probenträger in einer Apertur der Präparathalterungsvorrichtung eingelegt und dort fixiert. Alternativ hierzu kommen vermehrt mehrteilige Präparathalterungsvorrichtungen zum Einsatz, wie sie beispielsweise in der EP 1 868 225 A1 und der EP 1 947 675 A1 beschrieben sind. Bei diesen mehrteiligen Vorrichtungen wird der Probenträger zuerst in einer rahmenartigen Fassung, auch als Kartusche bezeichnet, fixiert und die Fassung anschließend in einer korrespondierenden Halterung der Präparathalterungsvorrichtung reversibel befestigt.

EM-Präparathalterungsvorrichtungen bzw. Fassungsvorrichtungen müssen spezifische Anforderungen erfüllen.

Neben höchster mechanischer Stabilität und Hochvakuumtauglichkeit ist insbesondere die Fixierung und Lagerung eines Probenträgers in der Präparathalterungsvorrichtung aufgrund der filigranen Natur der eingesetzten Probenträger von hoher Relevanz. Für eine störungsfreie Untersuchung und zum Vermeiden des Verlusts des Probenträgers muss der Probenträger stabil und schwingungsfrei fixiert werden. Weiters sind Verspannungen des filigranen Probenträgers zu vermeiden, da dieser ansonsten leicht zerstört wird. Bei den bekannten Präparathalterungsvorrichtungen, wie sie beispielsweise aus der EP 1947 675 A1 und der US 6,002,136 bekannt geworden sind, wird das Netzchen in der Apertur der Präparathalterungsvorrichtung mit Hilfe eines Sicherungsrings gehalten. Dieser Sicherungsring wird üblicherweise mit einem Werkzeug eingepresst, was sich nachteilig auf die Beschichtung des Probenträgers auswirkt. Diese Beschichtungen sind typischerweise sehr spröde und können durch ein Verspannen bei der Montage des Probenträgers und des Sicherungsrings leicht zerstört werden. Weiters sind die Sicherungsringe kleine Elemente, die umständlich zu handhaben sind und leicht verloren gehen können, besonders wenn sie in das Montagewerkzeug geladen werden müssen.

Für viele Anwendungen ist ein hochpräzises und stabiles Kippen des Präparats um eine oder mehrere in der Präparatebene liegende Achsen vorgesehen. Beispielsweise beschreibt die WO 00/10191 eine Side-Entry-Präparathalterungsvorrichtung mit Doppelkippung. Mit dem oben beschriebenen Aufbau unter Verwendung eines Sicherungsrings kann das Potential derartiger Anwendungen nachteiligerweise nicht zur Gänze ausgenützt werden. Sicherungsringe benötigen eine Nut, um den Probenträger auf die ringförmige Auflage in der Apertur zu pressen. Der Sicherungsring und die Nut erfordern einen ringförmigen Aufbau, der etwas kleiner als der Netzchendurchmesser ist. Dies führt zu einer Begrenzung des Kippwinkels und folglich zu einem geringeren Informationsgewinn aus der elektronenmikroskopischen Beobachtung.

Für bestimmte elektronenmikroskopische Anwendungen ist es weiters notwendig, dass die Probe von der Probenpräparationsvorrichtung in das TEM transferierbar ist und ein guter thermischer Kontakt zwischen der EM-Präparathalterungsvorrichtungen und der Probe besteht. Dies ist insbesondere bei kryoelektronenmikroskopischen Anwendungen in der Strukturbiologie wesentlich. Bei dieser Technologie wird eine wasserhältige Probe kryofixiert, d.h. sie wird sehr schnell und unter Vermeidung der Bildung von Eiskristallen abgekühlt. Die zu untersuchenden Objekte, beispielsweise Zellen, Enzyme, Viren oder Lipidschichten, werden dadurch in einer dünnen vitrifizierten Eisschicht eingebettet. Der Transfer der kryofixierten Probe bedeutet eine kritische Handhabung und Kontaminationsmöglichkeiten. Hierfür werden speziell gekühlte EM-Präparathalterungsvorrichtungen bzw. Fassungen eingesetzt, die den Transfer einer kryofixierten Probe ermöglichen.

Vorrichtungen zum Halten elektronenmikroskopischer Probenträger sind in der WO 03/087018A, der JP S60 164761 U1, der US 6,246,060 B1 und der US 2006/289784 A1 beschrieben.

Es ist eine daher Aufgabe der Erfindung, die oben angeführten Nachteile aus dem Stand der Technik zu beseitigen und darüber hinaus eine Ladevorrichtung bereitzustellen, welche den oben beschriebenen hohen Anforderungen entspricht. Folglich soll eine Ladevorrichtung zum Beladung einer Fassung mit einem elektronenmikroskopischen Probenträger bereitgestellt werden, mit welchem eine stabile, spannungsfreie Fixierung des Probenträgers möglich ist, so dass der Probenträger mit der Probe nicht beeinträchtigt wird. Weiters soll ein guter thermischer Kontakt zwischen der Fassung und dem Probenträger gewährleistet sein. Darüber hinaus soll die Fassung einen möglichst großen Kippwinkel ermöglichen.

Diese Aufgabe wird mit einer Ladevorrichtung gemäß dem unabhängigen Anspruch 1 und mit einem Verfahren gemäß dem unabhängigen Anspruch 15 gelöst.

Dank der Erfindung ist eine stabile und spannungsfreie Fixierung des Probenträgers möglich. Im Vergleich zu dem aus dem Stand der Technik bekannten Sicherungsring wird der Probenträger spannungsfrei gehalten. Auch die Montage gestaltet sich wesentlich einfacher und ein Verspannen des Probenträgers während der Montage wird vermieden. Dadurch wird die Gefahr der Zerstörung der Probenträger und der darauf befindlichen Proben sehr klein gehalten.

Trotz der spannungsfreien Fixierung des Probenträgers in der Fassung ist ein guter thermischer Kontakt zwischen der Fassung und dem Probenträger gegeben. Dies ist besonders wichtig für Präparate, bei welchen ein bestimmtes Temperaturniveau während der Untersuchung aufrecht erhalten werden muss.

Im Vergleich zum Aufbau unter Verwendung eines Sicherungsrings ermöglicht die Fassung einen größeren Kippwinkel, da keine ringförmige Nut bzw. kein ringförmiges Befestigungselement vorgesehen ist.

Ein weiterer Vorteil ist der einfache Aufbau und die einfache praktische Handhabung der Fassung, da hier auf kleine, verlierbare und umständlich zu handhabende Teile verzichtet werden kann. Probenträger können dank der Erfindung nicht nur einfach eingelegt, sondern auch ebenso einfach wieder aus der Fassung entfernt werden, ohne diese zu beschädigen.

Ferner hat sich gezeigt, dass die Fassung kostensparend herstellbar ist. Beispielsweise kann sie auch als Produkt zur einmaligen Benutzung hergestellt sein.

Die Fassung ist zweckmäßigerweise aus hochvakuumtauglichen Werkstoffen hergestellt. Hochvakuumtaugliche Werkstoffe dürfen keine Wassermoleküle oder Blei enthalten. Weiters sollte Sie keine poröse Oberfläche aufweisen. Bevorzugte Materialien sind Kupfer und Beryllium-Kupfer.

Die Fassung ist in erster Linie dazu vorgesehen, von einer elektronenmikroskopischen Präparathalterungsvorrichtung aufgenommen zu werden. Vorzugsweise ist die Präparathalterungsvorrichtung als Goniometer realisiert, wobei eine Realisierung in Form eines Side-Entry-Goniometers besonders bevorzugt ist. Die Funktionsweise und der grundsätzliche Aufbau eines Goniometers bzw. eines Side-Entry-Goniometers sind dem einschlägigen Fachmann gut bekannt. Die Fassung ist dabei in einer korrespondierenden Halterung der Präparathalterungsvorrichtung bzw. des Goniometers aufnehmbar und lösbar befestigbar. Beispielsweise beschreibt die EP 1 947 675 A1 eine Präparathalterungsvorrichtung, welche zwei parallele Haltestangen aufweist; die Haltestangen greifen in eine um den Außenrand der Fassung herumlaufende Nut ein. In der EP 1 868 225 A1 wird die Fassung mittels eines Schnappmechanismus in der Präparathalterungsvorrichtung befestigt.

Ebenso hierin beschrieben wird eine Präparathalterungsvorrichtung für ein Elektronenmikroskop, welches eine lösbar aufnehmbare Fassung umfasst.

Für viele Anwendungen ist ein hochpräzises und stabiles Kippen des Präparats um eine oder mehrere in der Präparatebene liegende Achsen notwendig. Folglich ist es von Vorteil, wenn die Fassung in der Präparathalterungsvorrichtung um zumindest eine in der Probenträgerebene liegende Achse, vorzugsweise um zwei in der Probenträgerebene liegende Achsen, kippbar gelagert ist. Derartige Kippmechanismen sind aus dem Stand der Technik bekannt und beispielsweise in der WO 00/10191 beschrieben.

Als weiterer Vorteil der Fassung ist an dieser Stelle die Transferierbarkeit der Fassung zu nennen, insbesondere die Transferierbarkeit von der Probenpräparationsvorrichtung, wie beispielsweise eine Kryokammer zum Präparieren von Proben für die Kryoelektronenmikroskopie, in ein Elektronenmikroskop. Die Fassung ist besonders für den Einsatz in der Transmissionselektronenmikroskopie, insbesondere in der Kryo-Transmissionselektronenmikroskopie, geeignet.

Die Fassung ist so konzipiert, dass sie zum Halten standardmäßiger elektronenmikroskopischer Probenträger geeignet ist. Hierfür werden bei der Herstellung der Fassung die Dimensionen der Öffnung in der Grundplatte, der Auflagefläche für den Probenträger und der Klammerelemente an den jeweiligen Probenträger angepasst. Typischerweise haben derartige Probenträger eine Standardgröße. Der hierin verwendete Begriff "Probenträger" bezieht sich auf alle einem einschlägigen Fachmann bekannten und für die Elektronenmikroskopie und für die elektronenmikroskopische Probenpräparation geeigneten Träger. Insbesondere bezieht sich der Begriff "Probenträger" auf die bereits oben erwähnten Grids ("Netzträger", "Netzchen", "Netz"), wobei die Grids verschiedenartig geformte Löcher (Waben, Schlitze etc.) oder ein Gitter definierter mesh-Zahl aufweisen und/oder mit einem Film beschichtet (z.B. beschichtete Grids der Firma Quantifoil) und/oder kohlebedampft sein können. Der Durchmesser standardmäßiger Grids beträgt typischerweise 2 bis 3 mm.

Anstelle des Begriffs "Fassung" wird im Folgenden auch der Begriff "Kartusche" mit derselben Bedeutung verwendet.

Erfindungsgemäß kann die Fassung zwei oder mehr Klammerelemente umfassen. Vorzugsweise umfasst die Fassung zwei bis drei Klammerelemente. Bei einer besonders bevorzugten Ausführungsform umfasst die Haltevorrichtung genau zwei Klammerelemente. Einerseits stellt dies die einfachste Bauweise dar und andererseits ist eine für die störungsfreie elektronenmikroskopische Beobachtung stabile und spannungsfreie Montage und Lagerung des Probenträgers möglich. Darüber hinaus ist ein sehr guter thermischer Kontakt gewährleistet. Da der Probenträger nur an zwei Randbereichen in der Fassung gehalten wird, ist ein großer Kippwinkel möglich. Beispielsweise kann eine Probenfläche mit einem Durchmesser von 2 mm unter einem Winkel von 70° im Elektronenmikroskop betrachtet werden (0° bedeutet senkrecht zur Probe).

Für ein stabiles Halten des Probenträgers in der Fassung sind die Klammerelemente bei dieser Ausführungsform vorzugsweise einander gegenüber angeordnet.

Ein besonders schonendes und spannungsfreies Halten des Probenträgers in der Fassung ergibt sich, wenn die Klammerelemente streifenförmig (zungenförmig) ausgebildet und im Wesentlichen parallel zur Grundplatte angeordnet sind. Es ist natürlich auch möglich, dass die Klammerelemente drahtförmig mit einem runden Querschnitt ausgestaltet sind, allerdings wird die streifenförmige Ausgestaltung aus oben genannten Gründen bevorzugt.

Bei einer besonders bevorzugten und einfach zu realisierenden Ausführungsform sind die Klammerelemente als Federelemente ausgebildet. Der Probenträger wird dabei mittels Federkraft mit Vorspannung in Richtung der Grundfläche bzw. der Auflagefläche gehalten. Vorzugsweise ist das Federelement streifenförmig (zungenförmig) wie oben beschreiben ausgeführt.

Zweckmäßigerweise weist jedes Klammerelement ein auf der Grundplatte fixiertes erstes Ende und ein zur Öffnung hin orientiertes zweites Ende zum kraftschlüssigen Halten des Probenträgers auf der Auflagefläche auf. Das erste Ende des Klammerelements ist vorzugsweise durch eine Punktschweißung auf der Grundfläche fixiert.

Vorzugsweise schließt das zweite Ende des Klammerelements mit dem Rand der Auflagefläche an der Öffnung ab. Der Probenträgers wird besonders sicher in der Fassung gehalten, da die gesamte Breite der Auflagefläche ausgenützt wird und andererseits erstreckt sich das zweite Ende des Klammerelements nicht in die Öffnung in der Grundfläche hinein und ermöglicht dadurch einen ungestörten Durchtritt des Elektronenstrahls.

Die Fassung weist eine auf der Grundplatte angeordnete Deckplatte auf, wobei die Deckplatte in einem Mittelbereich einen offenen, den Zugang zum Probenträger und zu den Klammerelementen ermöglichenden Bereich, aufweist. Der offene Bereich im Zugang zum Probenträger ist vorzugsweise so ausgestaltet, dass der Probenträger in diesen Bereich eingepasst werden kann. Dies erleichtert das Orientieren des Probenträgers in der Fassung. In Bezug auf den Zugang zu den Klammerelementen ist der offene Bereich in der Deckplatte so gestaltet, dass die Klammerelemente zum Einlegen des Probenträgers manipulierbar sind.

Bei einer vorteilhaften Ausführungsform ist das erste Ende eines jeden Klammerelements zwischen der Grundplatte und der Deckplatte fixiert. Das zweite Ende eines jeden Klammerelements ist im offenen Bereich der Deckplatte angeordnet und daher zugänglich. Dadurch wird eine sehr kompakte und leicht zu manipulierende Fassung erhalten. Grundplatte, Klammerelemente und Deckplatte sind vorzugsweise durch Punktschweissen miteinander verbunden. Der Mittelbereich der Deckplatte entspricht im Wesentlichen dem Mittelbereich der Grundplatte. Bei dieser aus zwei Platten zusammengesetzten Fassung ist die obere Deckplatte entsprechend elastisch ausgebildet, um ein Verschweißen mit der Grundplatte zu ermöglichen.

Bei einer weiteren vorteilhaften Ausführungsform weist die Fassung eine zwischen der Grundplatte und der Deckplatte angeordnete Zwischenplatte auf, wobei die Klammerelemente Komponenten der Zwischenplatte sind. Die Zwischenplatte weist in einem Mittelbereich einen offenen Bereich, der vorzugsweise im Wesentlichen dem offenen Bereich der Deckplatte entspricht, wobei sich die Klammerelemente in den offenen Bereich erstrecken. Bei dieser aus drei Platten zusammengesetzten Fassung ist die Zwischenplatte vorzugsweise einteilig mit den Klammerelementen ausgebildet, wobei die Dicke der Zwischenplatte vorzugweise der Dicke der Klammerelemente entspricht.

Für eine schonende und handliche Montage des Probenträgers in der Fassung ist es aus praktischen Gründen von Vorteil, wenn der offene Bereich in der Deckplatte eine Größe hat, die ein exzentrisches Einlegen des Probenträgers gestattet, wobei der Probenträger neben jener Position, in welcher der Probenträger in der Fassung haltbar ist, in die Fassung einlegbar und anschließend in die Position, in welcher der Probenträger in der Fassung haltbar ist, lateral verschiebbar ist. Bei Ausführungsformen, in welchen eine Zwischenplatte verwendet wird, entspricht der offene Bereich der Zwischenplatte wiederum wie oben erwähnt im Wesentlichen dem offenen Bereich der Deckplatte, sodass ein Zugang zur Auflagefläche bzw. zum Probenträger gewährleistet ist. Die Klammerelemente erstrecken sich in den offenen Bereich.

Für bestimmte elektronenmikroskopische Anwendungen weist die Fassung einen Außenrand mit einer drehsymmetrischen Gestaltung, insbesondere entsprechend einer vierzähligen Drehsymmetrie auf. Vorzugsweise ist die Fassung im Wesentlichen polygonal, insbesondere viereckig ausgeführt

Bei einer weiteren Ausführungsform weist die Fassung einen im Wesentlichen runden Außenrand auf. Für viele Anwendungen ist ein hochpräzises und stabiles Kippen des Präparats um eine oder mehrere in der Präparatebene liegende Achsen notwendig. Unter "im Wesentlichen rund" ist ein Außenrand zu verstehen, der vorzugsweise kreisrund ist. Der Außenrand kann aber auch oval ausgebildet sein. Ein runder Außenrand ist besonders von Vorteil, wenn die Fassung in einem sogenannten "Double-Tilt-Goniometer" zum Einsatz kommt. Double-Tilt-Goniometer sind dem einschlägigen Fachmann gut bekannt. Beispielsweise beschreibt die WO 00/10191 eine derartige Side-Entry-Präparathalterungsvorrichtung mit Doppelkippung. Zu erwähnen sind daher Double-Tilt-Goniometer, die eine Fassung wie hierin beschrieben aufweisen.

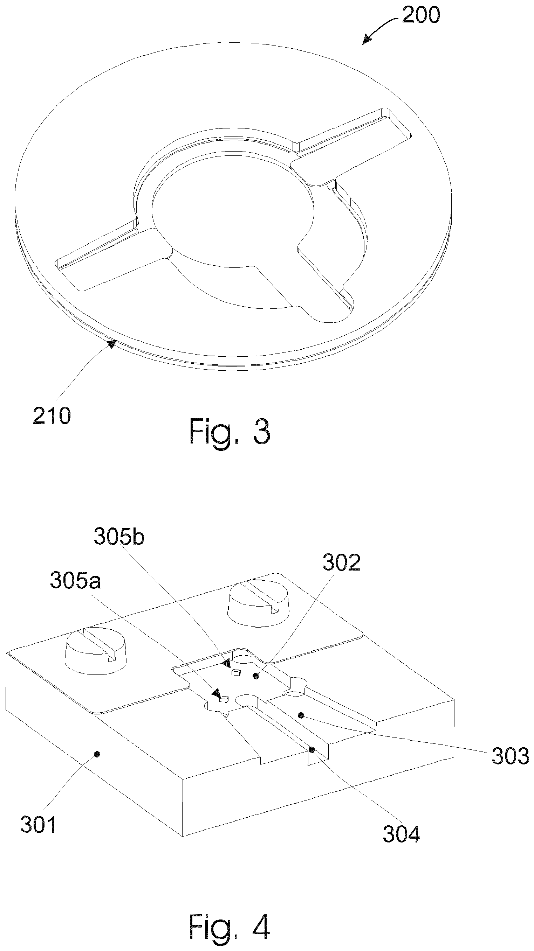

Für die Montage des Probenträgers in der Fassung ist es bei einer bevorzugten Ausführungsform vorgesehen, dass unterhalb eines jeden Klammerelements eine sich durch die Grundplatte hindurch erstreckende Öffnung angeordnet ist. Die Klammerelemente können mit Hilfe von Eingreifelementen, welche von unten durch die Öffnung eingeführt werden, angehoben werden. Nach Einlegen des Probenträgers wird dieser durch Entfernen des Werkzeugs und Herabsenken der Klammerelemente in ihre ursprüngliche Position in der Fassung gehalten. Eine erfindungsgemäße Ladevorrichtung zum Montieren des Probenträgers in der Fassung und das Montageverfahren werden im Folgenden sowie weiter unten in den Fig. 4 bis 7 im Detail beschrieben.

Die Erfindung betrifft wie oben genannt eine Ladevorrichtung zum Beladen einer Fassung mit einem elektronenmikroskopischen Probenträger, umfassend:
- eine Fassung, bei welcher unterhalb eines jeden Klammerelements eine sich durch die Grundplatte hindurch erstreckende Öffnung angeordnet ist, und
- ein Ladehilfselement, in welche die Fassung einlegbar ist, wobei das Ladehilfselement Eingreifelemente aufweist, welche sich durch die unterhalb eines jeden Klammerelements in der Grundplatte der Fassung angeordneten Öffnungen hindurch erstrecken und welche die Klammerelemente der Fassung entgegen ihrer Haltekraft in eine Richtung weg von der Grundplatte bewegen.

Die am Ladehilfselement angeordneten Eingreifelemente sind vorzugsweise stiftförmig ausgebildet. Das Ladehilfselement ist vorzugsweise blockförmig ausgebildet und weist zum leichteren Orientieren der Fassung beim Einlegen eine Ausnehmung auf, die der äußeren Form der Fassung entspricht. Dadurch ist es möglich, die in der Grundplatte der Fassung angeordneten Öffnungen korrekt zu den auf dem Ladehilfselement angeordneten Eingreifelementen zu orientieren.

Die Erfindung betrifft weiters ein Verfahren zum Beladen einer Fassung mit einem elektronenmikroskopischen Probenträger mittels einer Ladevorrichtung wie oben beschrieben, mit den Schritten:
a) Einlegen der Fassung in das Ladehilfselement,
b) Bewegen der Klammerelemente mittels der Eingreifelemente des Ladehilfselements in eine Richtung weg von der Grundplatte in eine angehobene Position,
c) Einlegen des Probenträgers auf die Auflagefläche der Fassung, und
d) Entfernen der Fassung von dem Ladehilfselement und kraftschlüssiges Halten des Probenträgers auf der Auflagefläche durch Zurückbewegen der Klammerelemente in ihre ursprüngliche Position.

Die Klammerelemente sind für die Durchführung des Verfahrens besonders bevorzugt als Federelemente ausgeführt.

Im Folgenden wird die Erfindung samt weiteren Vorzügen anhand eines nicht einschränkenden Ausführungsbeispiels erläutert, das in den beigefügten Zeichnungen dargestellt ist. Die Zeichnungen zeigen:
Fig. 1 eine perspektivische Ansicht einer ersten Ausführungsform der Kartusche (Fassung),
Fig. 2 eine perspektivische Ansicht der Unterseite der Kartusche aus Fig. 1,
Fig. 3 eine perspektivische Ansicht einer zweiten Ausführungsform der Kartusche (Fassung),
Fig. 4 eine perspektivische Ansicht eines Ladehilfselements ohne eingelegter Kartusche,
Fig. 5 das Ladehilfselement aus Fig. 4 mit der eingelegten Kartusche aus Fig. 1,
Fig. 6 das Ladehilfselement aus Fig. 5 mit einem in der Kartusche exzentrisch positionierten elektronenmikroskopischen Probenträger,
Fig. 7 das Ladehilfselement aus Fig. 6, in welchem der Probenträger in der Kartusche in seine Halteposition geschoben ist,
Fig. 8 eine perspektivische Ansicht eines Bereichs eines Goniometers mit einer darin montierten Kartusche aus Fig. 1, und
Fig. 9 eine perspektivische Ansicht eines Bereichs eines Goniometers mit einer darin montierten Kartusche aus Fig. 3.

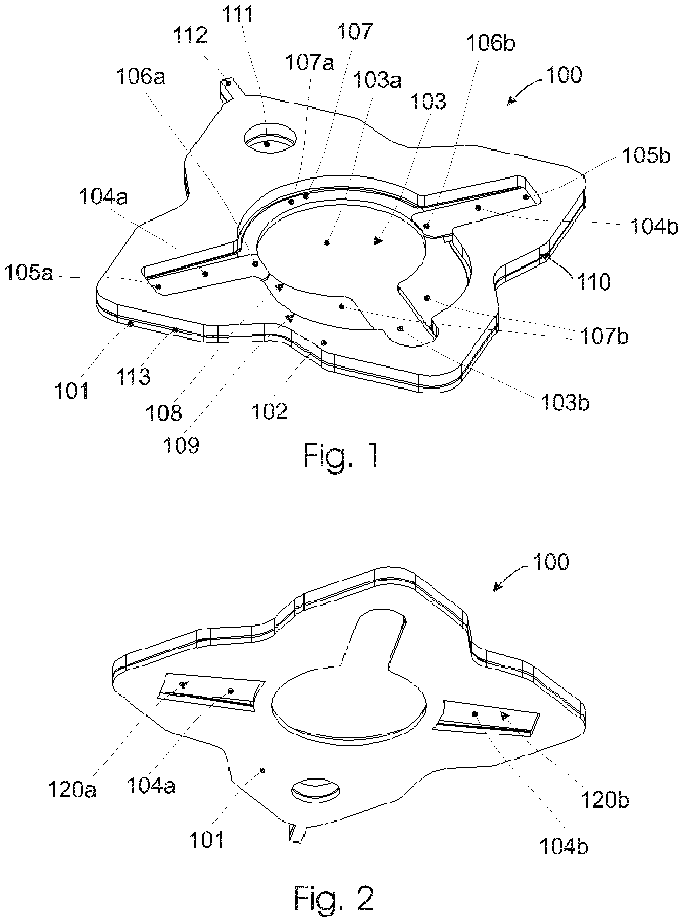

Fig. 1 zeigt eine Kartusche 100 zum Halten eines elektronenmikroskopischen Probenträgers. Die Kartusche 100 weist eine Grundplatte 101, eine Deckplatte 102, eine zwischen der Grundplatte 101 und der Deckplatte angeordnete Zwischenplatte 113 sowie eine in einem Mittelbereich der Grundplatte 101, der Zwischenplatte 113 und der Deckplatte 102 durch diese verlaufende Apertur 103 auf. Die Apertur 103 definiert im Strahlengang des Transmissionselektronenmikroskops einen Durchgang für den Elektronenstrahl. Die Apertur 103 umfasst einen runden Aperturbereich 103a, in welchem der elektronenmikroskopische Probenträger (nicht dargestellt), der im gezeigten Beispiel ein Grid ist, angeordnet wird. Die Apertur 103 umfasst ferner einen länglichen Aperturbereich 103b, welcher das Einlegen des Probenträgers mittels einer Pinzette ermöglicht. Die Kartusche 100 weist weiters zwei Klammerelemente 104a und 104b auf. Die Klammerelemente 104a,104b sind Komponenten der Zwischenplatte 113, wobei die Zwischenplatte 113 und die Klammerelemente 104a,104b einteilig ausgebildet ist. Die Dicke der Zwischenplatte 113 entspricht der Dicke der Klammerelemente 104a,104b. Die Klammerelemente 104a,104b sind als streifenförmige Federelemente ausgebildet, die sich auf der Grundplatte zur Apertur 103 hin erstrecken.

Die Grundplatte 101 weist ferner eine die Apertur 103 teilweise umlaufende Auflagefläche 107 für einen elektronenmikroskopischen Probenträger auf. Die Auflagefläche 107 kann die Apertur 103 natürlich auch zur Gänze umlaufen (nicht gezeigt). Die Auflagefläche 107 weist einen ersten Auflageflächenbereich 107a und einen größer ausgebildeten zweiten Auflageflächenbereich 107b auf. Der größere zweite Auflageflächenbereich 107b erleichtert die Montage des Probenträgers in der Kartusche wie weiter unten in den Fig. 4 bis 7 näher beschrieben wird. Die Grundplatte 101 weist weiters einen offenen Grundplattenbereich 108 auf, welcher der Apertur 103 entspricht. Die Deckplatte 102 weist einen offenen Deckplattenbereich 109 auf, der größer als der offene Grundplattenbereich 108 ausgebildet ist und einen Zugang zur Auflagefläche 107 und den Klammerelementen 104a,104b ermöglicht. Die Zwischenplatte 113 weist in einem Mittelbereich einen offenen Zwischenplattenbereich auf, der im Wesentlichen dem offenen Deckplattenbereich 109 entspricht, wobei sich die Klammerelemente 104a,104b in den offenen Zwischenplattenbereich erstrecken.

Jedes Klammerelement 104a,104b besitzt ein von der Zwischenplatte 113 ausgehendes erstes Ende 105a,105b sowie ein freies, zweites Ende 106a,106b, welches sich zur Apertur 103 hin erstreckt. Die Federkraft der Klammerelemente 104a,104b ist in Richtung Grundplatte 101 gerichtet. Die Klammerelemente 104a,104b sind im gezeigten Beispiel einander gegenüber angeordnet. Die zweiten Enden 106a,106b schließen mit dem Rand der Auflagefläche 107 an der Apertur 103 ab.

Bei einer nicht dargestellten alternativen Ausführungsform, die jedoch aus den gezeigten Figuren ohne Weiteres abgeleitet werden kann, weist die Kartusche keine Zwischenplatte 113, sondern lediglich eine Grundplatte 101 und eine Deckplatte 102 auf. Die ersten Enden 105a,105b eines jeden Klammerelements 104a,104b gehen bei dieser alternativen Ausführungsform folglich nicht von der Zwischenplatte 113 aus, sondern sind zwischen der Grundplatte 101 und der Deckplatte 102 fixiert. Bei dieser aus zwei Platten zusammengesetzten Kartusche ist die Deckplatte entsprechend elastisch ausgebildet, um ein Verschweißen mit der Grundplatte zu ermöglichen.

In der Kartusche 100 ist eine die Grundplatte 101, die Zwischenplatte 113 und die Deckplatte 102 durchlaufende Bohrung 111 dargestellt, welche lediglich als Fertigungshilfe und der Positionierung der Platten zueinander dient, wenn diese verschweißt werden. Am Außenrand 100 der Kartusche 100 ist ein Steg 112 angeordnet, der ebenfalls als Fertigungshilfe dient. Der Steg 112 wird nach dem Verschweißen von der Kartusche abgetrennt.

Die Grundplatte 101, die Zwischenplatte 113 mit den Klammerelementen 104a,104b und die Deckplatte 102 sind unlösbar durch Punktschweißen miteinander verbunden. Damit die Kartusche 100 eine möglichst glatte und polierte Oberfläche aufweist, können die einzelnen Komponenten oberflächenbehandelt sein, beispielsweise durch Gleitschleifen (Trowalisieren®).

Die Kartusche 100 ist insbesondere zur Aufnahme in einem Side-Entry-Goniometer (Goniometer mit Seitenenführung) vorgesehen. Es ist jedoch auch möglich, die Kartusche 100 in einem Top-Entry-Goniometer zu verwenden.

Die in Fig. 1 gezeigte Kartusche 100 hat einen Außenrand 110 mit einer drehsymmetrischen Gestaltung entsprechend einer vierzähligen Drehsymmetrie (90° Symmetrie), welche für bestimmte Anwendungen notwendig ist. Wenn das Goniometer, in welches die Kartusche 100 eingesetzt wird, nur eine Kippachse hat, kann die Kartusche 100 außerhalb des Transmissionselektronenmikroskops um einen definierten Winkel, d.h. um 90°, gedreht werden. Folglich ist nach einer erfolgten Drehung der Kippwinkel im Transmissionselektronenmikroskop ebenfalls um 90° verdreht, was einer Drehung um zwei senkrechte Achsen entspricht.

Fig. 2 zeigt eine perspektivische Ansicht der Unterseite der Kartusche 100. Die Grundplatte 101 weist zwei sich durch die Grundplatte hindurch erstreckende Öffnungen 120a,120b auf, die direkt unterhalb der Klammerelemente 104a,104b angeordnet sind und einen Zugang zu den Klammerelementen 104a,104b ermöglichen. Wie weiter unten zu den Fig. 4 bis 7 beschrieben wird, können die Klammerelemente 104a,104b zum Einlegen des elektronenmikroskopischen Probenträgers mit Hilfe von stiftförmigen Eingreifelementen, welche von unten durch die Öffnungen 120a,120b geführt werden, entgegen ihre Federkraft angehoben werden.

Die Fig. 3 zeigt eine Kartusche 200, die sich von der in den Fig. 1 und Fig. 2 gezeigten Kartusche 100 dadurch unterscheidet, dass sie einen runden Außenrand 210 aufweist. Die in der Kartusche 100 gezeigten Fertigungshilfen (Bohrung 111, Steg 112) sind in der Kartusche 200 nicht dargestellt. Die restlichen Merkmale der Kartusche 200 sind analog zu jenen der Kartusche 100. Mittels der Kartusche 200 ist eine Doppelkippung realisierbar. Folglich ist diese zur Verwendung in einem "Double-Tilt-Goniometer" besonders geeignet. Double-Tilt-Goniometer sind dem einschlägigen Fachmann gut bekannt.

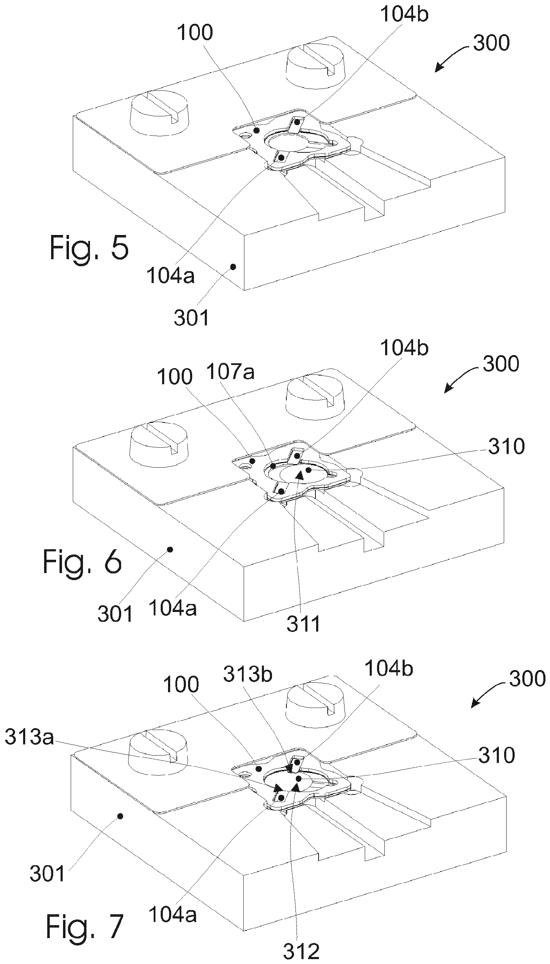

Die in den Beispielen gezeigten Kartuschen 100,200 sind für die Aufnahme eines Probenträgers in Form eines Grids (Grid 310, siehe Fig. 6 und Fig. 7) wie oben erwähnt, dimensioniert, da diese in der Praxis am häufigsten verwendet werden. Einem Fachmann auf dem Gebiet wird jedoch klar sein, dass die Kartusche auch für elektronenmikroskopische Probenträger, die einen anderen Durchmesser oder eine andere äußere Form als die standardmäßigen Grids aufweisen, dimensioniert sein kann.

Im Folgenden zeigen die Fig. 4 bis 7 eine Ladevorrichtung gemäß der Erfindung zum Beladen einer Kartusche mit einem elektronenmikroskopischen Probenträger und veranschaulichen das Beladungsverfahren.

Die erfindungsgemäße Ladevorrichtung 300 ist in der Fig. 5 gezeigt und umfasst eine Kartusche, welche im gezeigten Beispiel die oben beschriebene Kartusche 100 ist, sowie eine blockförmige Ladehilfe 301. Bezug nehmend auf die Fig. 4 weist die Ladehilfe eine Ausnehmung 302 auf, die der äußeren Form der Kartusche 100 entspricht und in welche diese, wie in der Fig. 5 gezeigt, einlegbar ist. Die Kartusche 100 ist seitlich über eine Führung 303 in die Ladehilfe 301 einschiebbar. Ein seitliches Einschieben und Entfernen der Kartusche 100 ist dadurch wesentlich einfacher und handlicher, als wenn das Einlegen und Entfernen der Kartusche 100 von oben erfolgen müsste. Zum bequemen Erfassen der Kartusche 100 mit einer Greifhilfe, z.B. einer Pinzette, beim Einlegen und Entfernen der Kartusche 100 in die Ladehilfe, weist die Ladehilfe 301 eine in der Mitte der Führung 303 angeordnete Vertiefung 304 auf. In der Ausnehmung 302 sind ferner zwei stiftförmige Eingreifelemente 305a,305b angeordnet, deren Zweck im Folgenden veranschaulicht wird.

Die Fig. 5 zeigt die Ladehilfe 301 mit der darin eingelegten Kartusche 100. Die Eingreifelemente 305a,305b sind an den Öffnungen 120a,120b, die sich an der Unterseite der Kartusche 100 befinden, ausgerichtet. Durch das Absenken der Kartusche 100 in die Ausnehmung 302 der Ladehilfe 301 gleiten die stiftförmigen Eingreifelemente 305a,305b in die Öffnungen 120a,120b hinein und heben dadurch die federnden Klammerelemente 104a,104b gegen ihre Federkraft weg von der Auflagefläche 107 nach oben in eine angehobene Position.

Fig. 6 zeigt die Ladevorrichtung 300 gemäß der Erfindung mit einem, auf dem größeren zweiten Auflageflächenbereich 107b der Kartusche 100 positionierten Grid 310. Das Grid 310 befindet sich hierbei vorerst in einer exzentrischen Position (mit dem Bezugszeichen 311 gekennzeichnet), also neben der eigentlichen Halteposition, in welcher das Grid 310 in der Kartusche gehalten wird. Im nächsten Schritt wird das Grid 310 lateral in Richtung des ersten Auflageflächenbereichs 107a verschoben, so dass es sich, wie in der Fig. 7 gezeigt, nunmehr in der Halteposition (mit dem Bezugszeichen 312 gekennzeichnet) auf dem ersten Auflagenbereich 107a der Kartusche 100 und unter den sich in der angehobenen Position befindlichen Klammerelementen 104a,104b befindet. Durch Anheben der Kartusche 100 federn die Klammerelemente 104a,104b in ihre ursprüngliche Position zurück und halten das Grid 310 an seinen Randbereichen 313a,313b, so dass dieses sicher in der Kartusche 100 fixiert ist. Wie aus der Fig. 7 gut ersichtlich ist, sind die Randbereiche 313a,313b beabstandet. Das in den Fig. 4 bis 7 veranschaulichte Verfahren ermöglicht eine stabile und spannungsfreie Montage und Lagerung des Grids 310. Darüber hinaus ist ein sehr guter thermischer Kontakt zwischen dem Grid 310 und der Kartusche 100 gewährleistet. Da das Grid 310 nur an zwei Randbereichen 313a,313b in der Kartusche 100 gehalten wird, ist ein großer Kippwinkel möglich. Nach dem Fixieren des Grids 310 in der Kartusche 100 kann die Kartusche 100 aus der Ladehilfe 301 entfernt und in einem Goniometer montiert werden.

Das in den Fig. 3 bis 7 gezeigte Verfahren lässt sich analog mit der Kartusche 200 aus der Fig. 3 bzw. mit jeder Kartusche durchführen. Die Ausnehmung in der Ladehilfe ist in diesem Fall natürlich den Maßen der jeweiligen Kartusche entsprechend zu gestalten.

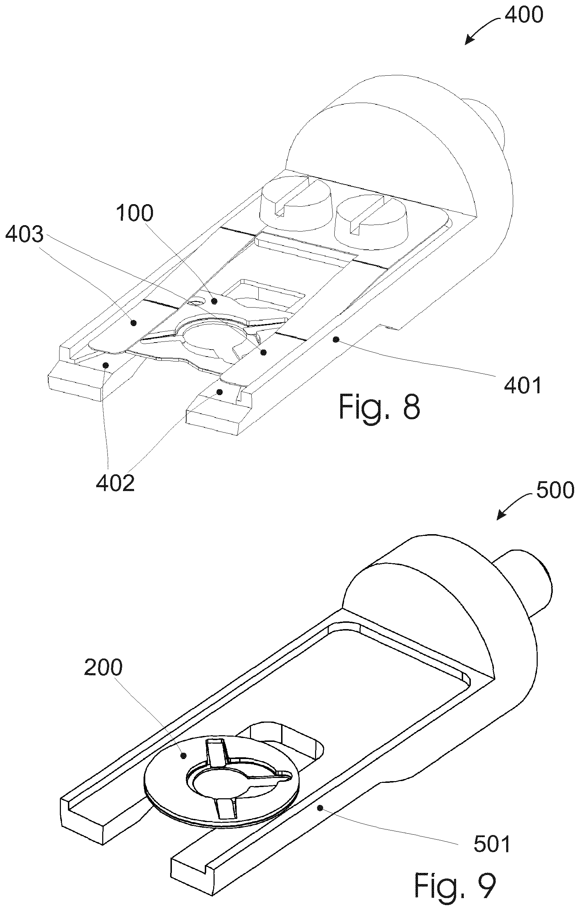

Die Fig. 8 zeigt einen Teil eines Goniometers 400 mit einer darin aufgenommenen Kartusche 100 (in der Abbildung ohne elektronenmikroskopischen Probenträger dargestellt). Der für die Aufnahme der Kartusche 100 vorgesehene Aufnahmebereich 401 des Goniometers 400 ist gabelförmig ausgebildet. Die Kartusche 100 wird auf länglichen Auflageflächen 402 des Aufnahmebereichs 401 aufgelegt und mittels zwei federnden Klammern 403 auf dem Goniometer fixiert.

Analog zur Fig. 8 zeigt die Fig. 9 ein Goniometer 500 mit einer darin aufgenommenen Kartusche 200 mit rundem Außenrand, wobei die federnden Klammern zum Halten der Kartusche 200 im gabelförmigen Aufnahmebereich 501 des Goniometers 500 nicht dargestellt sind.

Aus dem Stand der Technik sind weitere Mechanismen zum Halten eines einer Kartusche (Fassung) für einen Probenträger in einem Goniometer bekannt. Ein Fachmann wird daher in der Lage sein, die Kartusche so zu gestalten, dass diese Mechanismen auch für eine Kartusche anwendbar sind. Beispielsweise ist der in der EP 1 947 675 A1 gezeigte Mechanismus auch für eine Kartusche geeignet. Das in der EP 1 947 675 A1 beschriebene Goniometer weist einen gabelförmigen Aufnahmebereich aus, der zwei parallel ausgerichteten Stangen umfasst. Die Stangen greifen in eine, den Außenrand der Kartusche umlaufende Nut ein und fixieren die Kartusche auf diese Art und Weise im Goniometer. Dieser Haltemechanismus wäre auch für die Kartusche realisierbar. Hierfür würden die in den Beispielen gezeigten Kartuschen 100, 200 mit einer den Außenrand der Kartusche umlaufenden Nut versehen werden (nicht dargestellt). Als weiteres Beispiel seinen an dieser Stelle nochmals die Double-Tilt-Goniometer genannt, bei welchen die Kartusche in um zwei in der Probenträgerebene liegende Achsen schwenkbar gelagert ist (siehe WO 00/10191). Andere bekannte Goniometer erlauben eine Kippung der Kartusche lediglich um eine Achse.

Die oben beschriebenen Verwirklichungen der Erfindung sind nur Beispiele unter vielen und sind folglich nicht als einschränkend zu betrachten.

## Patentansprüche

1. Ladevorrichtung (300) zum Beladen einer Fassung (100,200) mit einem elektronenmikroskopischen Probenträger, **dadurch gekennzeichnet, dass** die Ladevorrichtung (300) eine Fassung (100,200) und ein Ladehilfselement (301), in welche die Fassung (100,200) einlegbar ist, umfasst,
wobei die Fassung (100,200) zum Halten eines elektronenmikroskopischen Probenträgers (310) ausgelegt ist und eine Grundplatte (101) mit einer in einem Mittelbereich der Grundplatte (101) durch diese verlaufende Öffnung (103) und einer die Öffnung (103) zumindest teilweise umlaufenden Auflagefläche (107) für den Probenträger (310) aufweist, wobei auf der Grundplatte (101) eine Haltevorrichtung (104a,104b) zum kraftschlüssigen Halten des Probenträgers (310) auf der Auflagefläche (107) vorgesehen ist, wobei die Haltevorrichtung (104a,104b) zum kraftschlüssigen Halten des Probenträgers (310) zumindest zwei voneinander unabhängige Klammerelemente (104a,104b) umfasst, welche sich von der Grundplatte (101) zur Öffnung (103) hin erstrecken und mittels welcher voneinander beabstandete Randbereiche (313a,313b) des elektronenmikroskopischen Probenträgers (310) auf der Auflagefläche (107) haltbar sind, und
wobei das Ladehilfselement (301) Eingreifelemente (305a,305b) aufweist, welche sich durch unterhalb eines jeden Klammerelements (104a,104b) in der Grundplatte (101) der Fassung (100,200) angeordnete Öffnungen (120a,120b) hindurch erstrecken und welche die Klammerelemente (104a,104b) der Fassung (100,200) entgegen ihrer Haltekraft in eine Richtung weg von der Grundplatte (101) bewegen.

2. Ladevorrichtung nach Anspruch 1, **dadurch gekennzeichnet, dass** die Haltevorrichtung genau zwei Klammerelemente (104a,104b) umfasst.

3. Ladevorrichtung nach Anspruch 2, **dadurch gekennzeichnet, dass** die Klammerelemente (104a,104b) einander gegenüber angeordnet sind.

4. Ladevorrichtung nach einem der Ansprüche 1 bis 3, **dadurch gekennzeichnet, dass** die Klammerelemente (104a,104b) streifenförmig ausgebildet und im Wesentlichen parallel zur Grundplatte (101) angeordnet sind.

5. Ladevorrichtung nach einem der Ansprüche 1 bis 4, **dadurch gekennzeichnet, dass** die Klammerelemente (104a,104b) als Federelemente ausgebildet sind.

6. Ladevorrichtung nach einem der Ansprüche 1 bis 5, **dadurch gekennzeichnet, dass** jedes Klammerelement (104a,104b) ein auf der Grundplatte (101) fixiertes erstes Ende (105a,105b) und ein zur Öffnung (103) hin orientiertes zweites Ende (106a,106b) zum kraftschlüssigen Halten des Probenträgers (310) auf der Auflagefläche (107) aufweist.

7. Ladevorrichtung nach Anspruch 6, **dadurch gekennzeichnet, dass** das zweite Ende (106a,106b) des Klammerelements (104a,104b) mit dem Rand der Auflagefläche (107) an der Öffnung (103) abschließt.

8. Ladevorrichtung nach einem der Ansprüche 1 bis 7, **gekennzeichnet durch** eine auf der Grundplatte (101) angeordnete Deckplatte (102), wobei die Grundplatte (101) einen offenen Grundplattenbereich (108) aufweist, welcher der Öffnung (103) entspricht, und wobei die Deckplatte (102) einen offenen Deckplattenbereich (109) aufweist, der größer als der offene Grundplattenbereich (108) ausgebildet ist und einen Zugang zur Auflagefläche (107) und den Klammerelementen (104a, 104b) ermöglicht.

9. Ladevorrichtung nach Anspruch 8, **dadurch gekennzeichnet, dass** das erste Ende (105a,105b) eines jeden Klammerelements (104a,104b) zwischen der Grundplatte (101) und der Deckplatte (102) fixiert ist.

10. Ladevorrichtung nach Anspruch 8, **gekennzeichnet durch** eine zwischen der Grundplatte (101) und der Deckplatte (102) angeordneten Zwischenplatte, wobei die Klammerelemente (104a,104b) Komponenten der Zwischenplatte sind.

11. Ladevorrichtung nach einem der Ansprüche 8 bis 10, **dadurch gekennzeichnet, dass** der offene Bereich (109) in der Deckplatte (102) eine Größe hat, die ein exzentrisches Einlegen des Probenträgers (310) gestattet, wobei der Probenträger (310) neben jener Position (312), in welcher der Probenträger (310) in der Fassung (100,200) haltbar ist, in die Fassung (100,200) einlegbar und anschließend in die Position (312), in welcher der Probenträger (310) in der Fassung (100,200) haltbar ist, lateral verschiebbar ist.

12. Ladevorrichtung nach einem der Ansprüche 1 bis 11, **dadurch gekennzeichnet, dass** unterhalb eines jeden Klammerelements (104a,104b) eine sich durch die Grundplatte (101) hindurch erstreckende Öffnung (120a,120b) angeordnet ist.

13. Ladevorrichtung nach einem der Ansprüche 1 bis 12, **dadurch gekennzeichnet, dass** die Fassung (100) einen Außenrand (110) mit einer drehsymmetrischen Gestaltung entsprechend einer vierzähligen Drehsymmetrie aufweist.

14. Ladevorrichtung nach einem der Ansprüche 1 bis 12, **dadurch gekennzeichnet, dass** die Fassung (200) einen im Wesentlichen runden Außenrand (210) aufweist.

15. Verfahren zum Beladen einer Fassung (100,200) mit einem elektronenmikroskopischen Probenträger (310) mittels einer Ladevorrichtung (300) nach einem der Ansprüche 1 bis 14, mit den Schritten:
a) Einlegen der Fassung (100,200) in das Ladehilfselement (301),
b) Bewegen der Klammerelemente (104a,104b) mittels der Eingreifelemente (305a,305b) des Ladehilfselements (301) in eine Richtung weg von der Grundplatte (101) in eine angehobene Position,
c) Einlegen des Probenträgers (310) auf die Auflagefläche (107) der Fassung (100,200), und
d) Entfernen der Fassung (100,200) von dem Ladehilfselement (310) und kraftschlüssiges Halten des Probenträgers (310) auf der Auflagefläche (107) durch Zurückbewegen der Klammerelemente (104a,104b) in ihre ursprüngliche Position.

## Claims

1. A loading apparatus (300) for loading a mount (100, 200) comprising an electron microscopy sample carrier, **characterized in that** the loading apparatus (300) comprises a mount (100, 200) and a loading assistance element (301), in which the mount (100, 200) can be inserted,
the mount (100,200) being designed to hold an electron microscopy sample carrier (310) and comprising a base plate (101) having an opening (103) that passes through a middle region of the base plate (101) and a support surface (107) for the sample carrier (310) that extends at least partly around the opening (103), a holding apparatus (104a, 104b) for holding the sample carrier (310) in a force-fit manner on the support surface (107) being provided on the base plate (101), the holding apparatus (104a, 104b) for holding the sample carrier (310) in a force-fit manner including at least two mutually independent clip elements (104a, 104b), which extend from the base plate (101) toward the opening (103) and by means of which mutually spaced edge regions (313a, 313b) of the electron microscopy sample carrier (310) can be held on the support surface (107), and
the loading assistance element (301) comprising engagement elements (305a, 305b), which extend through openings (120a, 120b) provided beneath each clip element (104a, 104b) in the base plate (101) of the mount (100, 200), and which move the clip elements (104a, 104b) of the mount (100, 200) against the holding force thereof in a direction away from the base plate (101).

2. The loading apparatus according to claim 1, **characterized in that** the holding apparatus comprises exactly two clip elements (104a, 104b).

3. The loading apparatus according to claim 2, **characterized in that** the clip elements (104a, 104b) are arranged opposite one another.

4. The loading apparatus according to any one of claims 1 to 3, **characterized in that** the clip elements (104a, 104b) are strip-shaped and arranged substantially parallel to the base plate (101).

5. The loading apparatus according to any one of claims 1 to 4, **characterized in that** the clip elements (104a, 104b) are designed as spring elements.

6. The loading apparatus according to any one of claims 1 to 5, **characterized in that** each clip element (104a, 104b) has a first end (105a, 105b) fixed on the base plate (101), and a second end (106a, 106b) oriented toward the opening (103) for holding the sample carrier (310) on the support surface (107) in a force-fit manner.

7. The loading apparatus according to claim 6, **characterized in that** the second end (106a, 106b) of the clip element (104a, 104b) is even with the edge of the support surface (107) at the opening (103).

8. The loading apparatus according to any one of claims 1 to 7, **characterized by** a cover plate (102) arranged on the base plate (101), the base plate (101) including an open base plate region (108) corresponding to the opening (103), and the cover plate (102) including an open cover plate region (109) which is designed larger than the open base plate region (108) and enables access to the support surface (107) and the clip elements (104a, 104b).

9. The loading apparatus according to claim 8, **characterized in that** the first end (105a, 105b) of each clip element (104a, 104b) is fixed between the base plate (101) and the cover plate (102).

10. The loading apparatus according to claim 8, **characterized by** an intermediate plate arranged between the base plate (101) and the cover plate (102), the clip elements (104a, 104b) being components of the intermediate plate.

11. The loading apparatus according to any one of claims 8 to 10, **characterized in that** the open region (109) in the cover plate (102) has a size that permits the sample carrier (310) to be inserted eccentrically, it being possible for the sample carrier (310) to be inserted into the mount (100, 200) alongside that position (312) in which the sample carrier (310) can be held in the mount (100, 200), and then to be laterally displaced into the position (312) in which the sample carrier (310) can be held in the mount (100, 200).

12. The loading apparatus according to any one of claims 1 to 11, **characterized in that** an opening (120a, 120b) extending through the base plate (101) is arranged beneath each clip element (104a, 104b).

13. The loading apparatus according to any one of claims 1 to 12, **characterized in that** the mount (100) comprises an outer edge (110) having a rotationally symmetrical configuration, corresponding to a four-fold rotational symmetry.

14. The loading apparatus according to any one of claims 1 to 12, **characterized in that** the mount (200) comprises a substantially round outer edge (210).

15. A method for loading a mount (100, 200) with an electron microscopy sample carrier (310) by way of a loading apparatus (300) according to any one of claims 1 to 14, comprising the following steps:
a) inserting the mount (100, 200) into the loading assistance element (301);
b) moving the clip elements (104a, 104b), by way of the engagement elements (305a, 305b) of the loading assistance element (301), in a direction away from the base plate (101) into a raised position;
c) inserting the sample carrier (310) onto the support surface (107) of the mount (100, 200); and
d) removing the mount (100, 200) from the loading assistance element (310), and holding the sample carrier (310) in a force-fit manner on the support surface (107) by moving the clip elements (104a, 104b) back into the original positions thereof.

## Revendications

1. Dispositif de chargement (300) pour le chargement d'une monture (100, 200) avec un porte-échantillon de microscopie électronique , **caractérisé par le fait que** le dispositif de chargement (300) comporte une monture (100, 200) et un élément (301) d'aide au chargement, dans lequel la monture (100, 200) est apte à être placée,
dans lequel la monture (100, 200) est conçue pour le maintien d'un porte-échantillon de microscopie électronique (310) et présente une plaque de base (101) ayant une ouverture (103) passant à travers une région centrale de la plaque de base (101) et une surface de support (107) entourant au moins partiellement l'ouverture (103) pour supporter le porte-échantillon (310), dans lequel sur la plaque de base (101) est prévu un dispositif de maintien (104a, 104b) pour le maintien par friction du porte-échantillon (310) sur la surface de support (107), dans lequel le dispositif de maintien (104a, 104b) pour le maintien par engagement par friction du porte-échantillon (310) comporte au moins deux éléments de pince (104a, 104b) indépendants l'un de l'autre, lesquels s'étendent à partir de la plaque de base (101) vers l'ouverture (103) et au moyen desquels des régions de bordure (313a, 313b) du porte-échantillon de microscopie électronique (310), espacées l'une de l'autre, sont aptes à être maintenues sur la surface de support (107), et
dans lequel l'élément (301) d'aide au chargement présente des éléments d'engagement (305a, 305b), lesquels s'étendent à travers des ouvertures (120a, 120b) disposées au-dessous d'un élément de pince respectif (104a, 104b) dans la plaque de base (101) de la monture (100, 200) et lesquels déplacent les éléments de pince (104a, 104b) de la monture (100, 200) à l'encontre de leur force de maintien dans une direction éloignée de la plaque de base (101).

2. Dispositif de chargement selon la revendication 1, **caractérisé par le fait que** le dispositif de maintien comporte exactement deux éléments de pince (104a, 104b).

3. Dispositif de chargement selon la revendication 2, **caractérisé par le fait que** les éléments de pince (104a, 104b) sont disposés à l'opposé l'un de l'autre.

4. Dispositif de chargement selon l'une des revendications 1 à 3, **caractérisé par le fait que** les éléments de pince (104a, 104b) sont réalisés en forme de bande et sont disposés sensiblement parallèlement à la plaque de base (101).

5. Dispositif de chargement selon l'une des revendications 1 à 4, **caractérisé par le fait que** les éléments de pince (104a, 104b) sont réalisés en tant qu'éléments à ressort.

6. Dispositif de chargement selon l'une des revendications 1 à 5, **caractérisé par le fait que** chaque élément de pince (104a, 104b) présente une première extrémité (105a, 105b) fixée sur la plaque de base (101) et une seconde extrémité (106a, 106b) orientée vers l'ouverture (103) pour le maintien par engagement par friction du porte-échantillon (310) sur la surface de support (107).

7. Dispositif de chargement selon la revendication 6, **caractérisé par le fait que** la seconde extrémité (106a, 106b) de l'élément de pince (104a, 104b) se termine à fleur du bord de la surface de support (107) à l'ouverture (103).

8. Dispositif de chargement selon l'une des revendications 1 à 7, **caractérisé par** une plaque de recouvrement (102) disposée sur la plaque de base (101), la plaque de base (101) présentant une région de plaque de base ouverte (108), laquelle correspond à l'ouverture (103), et la plaque de recouvrement (102) présentant une région de plaque de recouvrement ouverte (109), qui est réalisée plus grande que la région de plaque de base ouverte (108) et permet un accès à la surface de support (107) et aux éléments de pince (104a, 104b).

9. Dispositif de chargement selon la revendication 8, **caractérisé par le fait que** la première extrémité (105a, 105b) de chaque élément de pince (104a, 104b) est fixée entre la plaque de base (101) et la plaque de recouvrement (102).

10. Dispositif de chargement selon la revendication 8, **caractérisé par** une plaque intermédiaire disposée entre la plaque de base (101) et la plaque de recouvrement (102), les éléments de pince (104a, 104b) étant des composants de la plaque intermédiaire.

11. Dispositif de chargement selon l'une des revendications 8 à 10, **caractérisé par le fait que** la région ouverte (109) dans la plaque de recouvrement (102) présente une dimension qui permet au porte-échantillon (310) d'être mis en place de manière excentrique, le porte-échantillon (310) étant apte à être placé dans la monture (100, 200) le long de la position (312) dans laquelle le porte-échantillon (310) est apte à être maintenu dans la monture (100, 200), et ensuite étant apte à être déplacé latéralement dans la position (312) dans laquelle le porte-échantillon (310) est apte à être maintenu dans la monture (100, 200).

12. Dispositif de chargement selon l'une des revendications 1 à 11, **caractérisé par le fait qu'**une ouverture respective (120a, 120b) s'étendant à travers la plaque de base (101) est disposée au-dessous de chaque élément de pince (104a, 104b).

13. Dispositif de chargement selon l'une des revendications 1 à 12, **caractérisé par le fait que** la monture (100) présente un bord externe (110) ayant une configuration de symétrie de rotation correspondant à une symétrie de rotation d'ordre quatre.

14. Dispositif de chargement selon l'une des revendications 1 à 12, **caractérisé par le fait que** la monture (200) présente un bord externe (210) sensiblement rond.

15. Procédé de chargement d'une monture (100, 200) avec un porte-échantillon de microscopie électronique (310) au moyen d'un dispositif de chargement (300) selon l'une des revendications 1 à 14, comprenant les étapes :
a) placer la monture (100, 200) dans l'élément (301) d'aide au chargement ;
b) déplacer les éléments de pince (104a, 104b) dans une position relevée dans une direction éloignée de la plaque de base (101) au moyen des éléments d'engagement (305a, 305b) de l'élément (301) d'aide au chargement ;
c) placer le porte-échantillon (310) sur la surface de support (107) de la monture (100, 200) ; et
d) retirer la monture (100, 200) de l'élément (310) d'aide au chargement et maintenir par engagement par friction le porte-échantillon (310) sur la surface de support (107) par déplacement des éléments de pince (104a, 104b) pour les ramener dans leur position initiale.
